# EUROPEAN PATENT SPECIFICATION

(11) **EP 0 370 462 B1**
(45) Date of publication and mention of the grant of the patent: **08.11.1995**
(21) Application number: 89121520.4
(22) Date of filing: 21.11.1989
(51) Int. Cl.: H01L 21/00

(54) **Semiconductor treatment apparatus**
Vorrichtung zum Behandeln von Halbleitern
Dispositif de traitement de semi-conducteurs

(30) Priority: 21.11.1988 JP 293888/88
(43) Date of publication of application: 30.05.1990
(73) Proprietor: KABUSHIKI KAISHA TOSHIBA, Kawasaki-shi, Kanagawa-ken 210 (JP)
(72) Inventor: Kageyama, Mokuji Intellectual Property Division, Minato-ku Tokyo 105 (JP); Yoshikawa, Kiyoshi Intellectual Property Division, Minato-ku Tokyo 105 (JP); Shimazaki, Ayako Intellectual Property Division, Minato-ku Tokyo 105 (JP)
(74) Representative: Zangs, Rainer E., Dipl.-Ing.

(56) References cited:
- EP-A- 0 157 675
- US-A- 4 695 327

## Description

The present invention relates generally to a semiconductor treatment apparatus, and more particularly to an apparatus for recovering impurities on the surface of a semiconductor substrate.

It is well known that an impurity such as Na (sodium), K (potassium) or Fe (iron) included in a thin film thermal oxide film formed on a semiconductor substrate adversely affects the electrical characteristics of a semiconductor device, even if the amount of the impurity is very small. Thus, the electrical characteristics of the semiconductor substrate can be enhanced by preventing the impurity from being mixed in the substrate as much as possible.

As conventional methods of analyzing impurities over the surface of the semiconductor substrate, there are known secondary ion mass spectrometry (SIMS), Auger electron spectroscopy (AES), and activation analysis. These methods, however, require expensive apparatuses, and special skill is indispensable in operating such apparatuses. While these methods employ electron beams or light beams and allow local analysis, the evaluation of contamination over the entire surface of the semiconductor substrate cannot be achieved. Thus, the conventional methods are unsuitable for easy analysis of contamination of the entire surface of the substrate. Recently, as methods of analyzing the entire surface of the substrate, two methods have been proposed.

According to a first method or a decomposing method, an appropriate thermal oxide film is formed over the surface of a substrate, and the substrate is exposed to vapor of fluoride solution. The oxide film, dissolved by the vapor of fluoride solution, is recovered, in the form of fluoride solution, along with impurities contained in the oxide film. Thus, the impurities contained in the recovered fluoride solution are analyzed by an analyzing apparatus.

According to a second method, a semiconductor substrate, which has not been subjected to a thermal oxidation treatment, is immersed in fluoride solution, and a native oxide film formed on the surface of the substrate is dissolved. The types and concentrations of impurities contained in the native oxide film are examined by analyzing the fluoride solution.

The first method, however, includes a thermal oxidation process. Thus, there is a concern that an impurity may be mixed in the formed thermal oxide film from the atmosphere employed in the thermal oxidation process, impurities over the surface of the substrate may be evaporated, or impurities may be diffused from the inner region of the substrate to the surface region of the substrate. In the second method, the amount of fluoride solution necessary for recovering the impurities is excessively greater than that necessary for analyzing the impurities. Thus, the concentration of impurities in the recovered solution is too low to obtain precise analysis data, and impurities in a native oxide film formed on the back side surface of the substrate, which is not related to impurity analysis, are mixed in the fluoride solution.

The object of the present invention is to provide a semiconductor treatment device employed in carrying out an impurity measuring method, which can analyze impurities on the surface of a semiconductor substrate, with high precision and high reliability.

In order to achieve the above object, the present invention provides a semiconductor treatment apparatus according to claim 1. Advantageous embodiments are discribed in the subclaims.

This invention can be more fully understood from the following detailed description when taken in conjunction with the accompanying drawings, in which:
Fig. 1 is a block diagram for explaining the technical principle of a semiconductor treatment apparatus according to the present invention;
Fig. 2 is a side view of a semiconductor treatment apparatus according to a first embodiment of the present invention;
Fig. 3 is a plan view of the semiconductor treatment apparatus according to the first embodiment;
Fig. 4 is a front view of a clean booth;
Fig. 5 is a cross-sectional side view of the clean booth;
Fig. 6 is a cross-sectional view taken along line I-I in Fig. 4;
Figs. 7A to 7D are flowcharts for illustrating the operation of a control apparatus according to the first embodiment of the present invention;
Fig. 8 is a plan view of a semiconductor treatment apparatus according to a second embodiment of the present embodiment;
Fig. 9 is a side view of the semiconductor treatment apparatus according to the second embodiment;
Fig. 10 is a plan view showing the semiconductor treatment apparatus arranged within the clean booth;
Fig. 11A is a cross-sectional view of important portions of the semiconductor treatment apparatus shown in Figs. 8 and 9;
Fig. 11B is a plan view of the apparatus shown in Fig. 11A;
Figs. 12A and 12B show in detail a liquid-drop retainer of the semiconductor treatment apparatus shown in Figs. 8 and 9;
Figs. 13A to 13E are flowcharts for illustrating the operation of a control apparatus according to the second embodiment; and
Fig. 14 shows comparative data relating to limit analysis values of a method employing the apparatus of the present invention and conventional methods.

Embodiments of the present invention will now be described with reference to the accompanying drawings. In the drawings, the common elements are indicated by the same reference numeral.

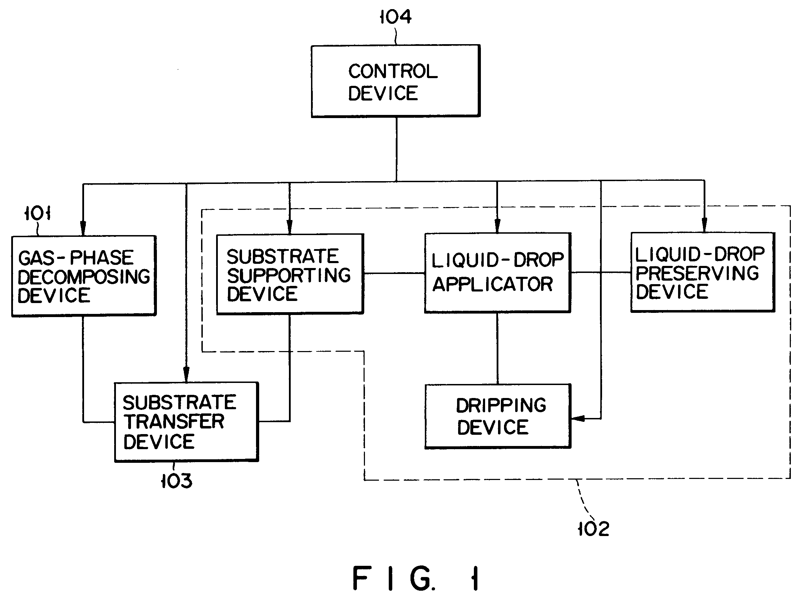

In Fig. 1, a decomposing device 101 dissolves the surface of a semiconductor substrate by exposing it to a vapor. A carrier for carrying the semiconductor substrate is arranged in the decomposing device 101. A rotary treatment device 102 recovers impurities adhered on the surface of the semiconductor substrate. The recovery of impurities is performed by using liquid-drops. A substrate transfer device 103 is designed to transfer the semiconductor substrate between the decomposing device 101 and the rotary treatment device 102. The substrate transfer device 103 is able to transfer one semiconductor substrate at a time. A control device 104 controls the operation timings of these devices 101, 102 and 103, for example, in a remote control mode using computer programs.

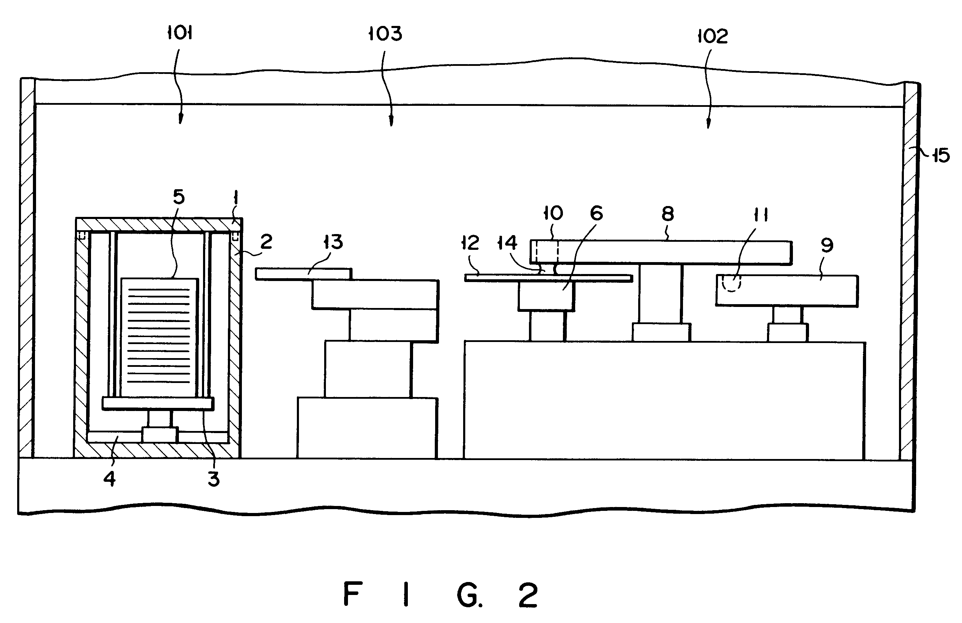

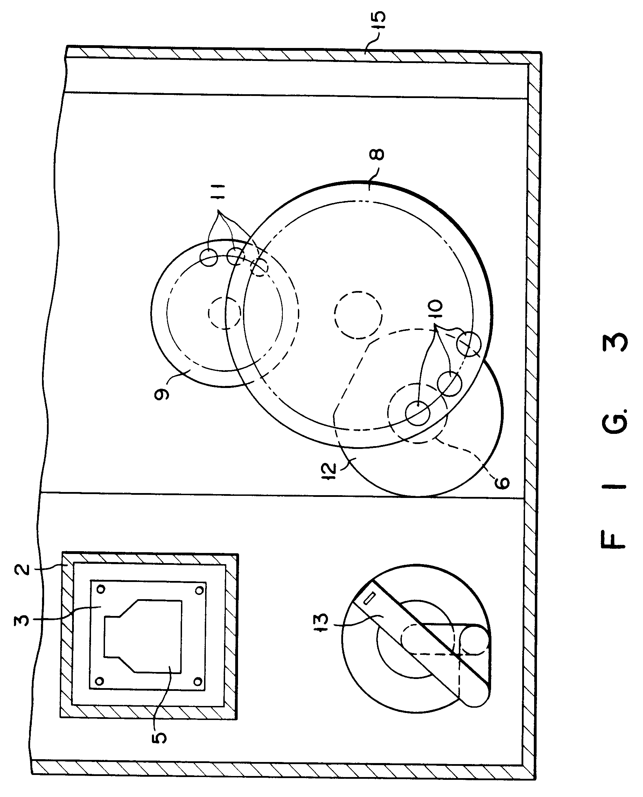

Figs. 2 and 3 show a first embodiment of the semiconductor treatment apparatus according to the present invention. Fig. 2 is a side view showing various devices constituting the semiconductor treatment apparatus. Fig. 3 is a plan view showing the devices, for clear understanding of the arrangement thereof.

A decomposing device 101 comprises a cover 1 made of resin, a container 2 made of resin and capable of being sealed by the cover 1, a carrier table 3 arranged in the container 2, and high-purity fluoride liquid 4 contained in the container 2. The cover 1 is coupled to the carrier table 3 and is vertically movable along with the carrier table 3. A carrier 5 for carrying the semiconductor substrate is placed on the carrier table 3.

A rotary treatment device 102 comprises a substrate supporting device (e.g., a vacuum chuck) 6, a liquid-drop applicator 8 and a liquid-drop collecting and preserving device (e.g., a reservoir) 9. The liquid-drop applicator 8 has a circular shape, and is provided with a plurality of liquid drop retainer sections 10 along its periphery. The liquid-drop collecting and preserving device 9 has a circular shape, and is provided with a plurality of recesses 11 along its periphery. The positional relationship between the substrate supporting device 6 and the liquid-drop applicator 8 is determined such that the axis of each liquid-drop retainer sections 10 is aligned with the center of the substrate supporting device 6 or the center of a semiconductor substrate 12 supported on the substrate supporting device 6. The liquid-drop applicator 8 and liquid-drop collecting and preserving device 9 overlap each other.

The substrate transfer device 103, with its arm 13 being extended or retracted, transfers the semiconductor substrate between the decomposing device 101 and the rotary treatment device 102, that is, between the carrier 5 and the substrate supporting device 6.

The devices 101 to 103 are installed in an apparatus (e.g., a glove box, clean booth, etc.) 15 for producing a clean-room, and is isolated from the outer space. The devices 101 to 103 can be operated in a remote control mode, since the control device 104 drives a control motor, etc. to establish the operation timings of the devices 101 to 103.

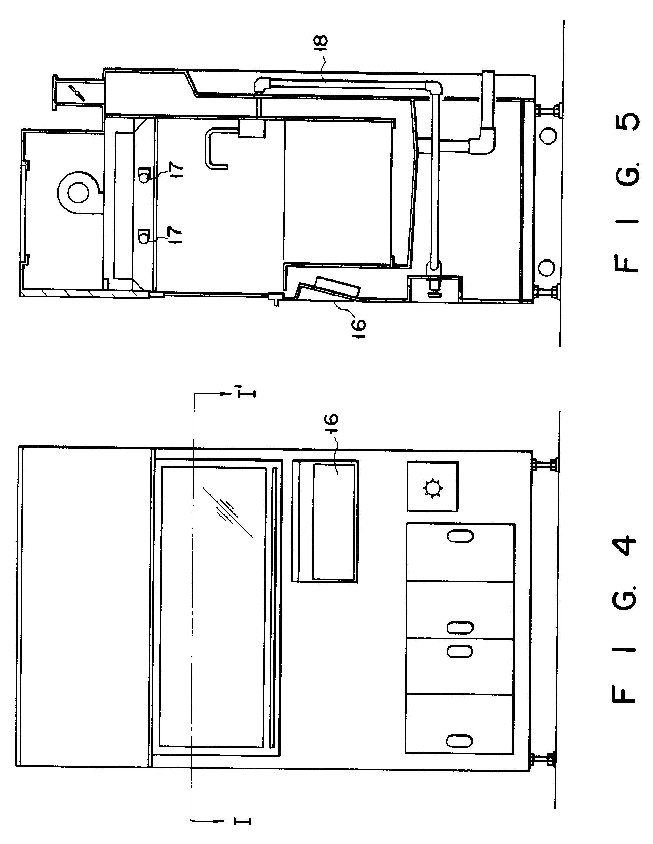

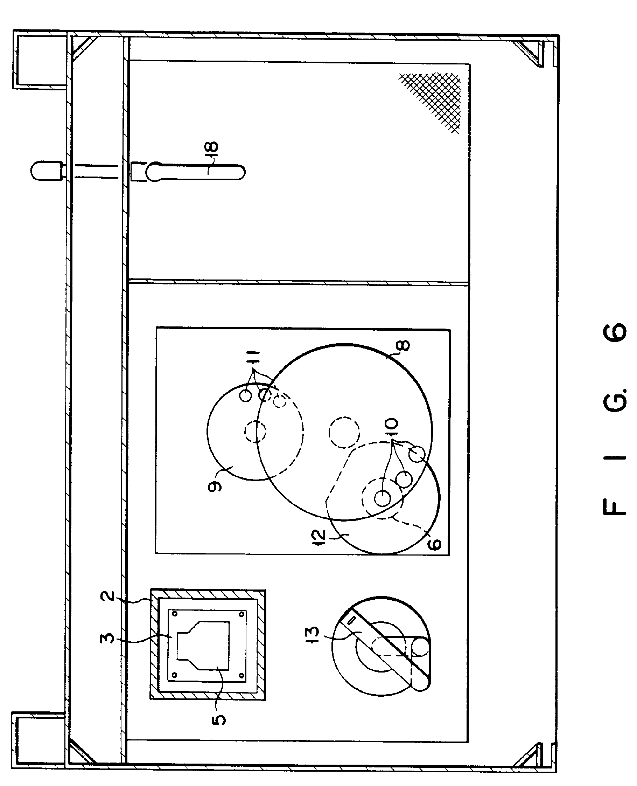

Figs. 4 to 6 show a clean booth in detail, as the apparatus 15 for producing a clean-room. Fig. 4 is a front view of the clean booth, Fig. 5 is a cross-sectional side view of the clean booth, and Fig. 6 is a cross-sectional view taken along line I-I′ in Fig. 4. Reference numeral 16 denotes a display, numeral 17 illumination devices, and numeral 18 a pipe for supplying pure water.

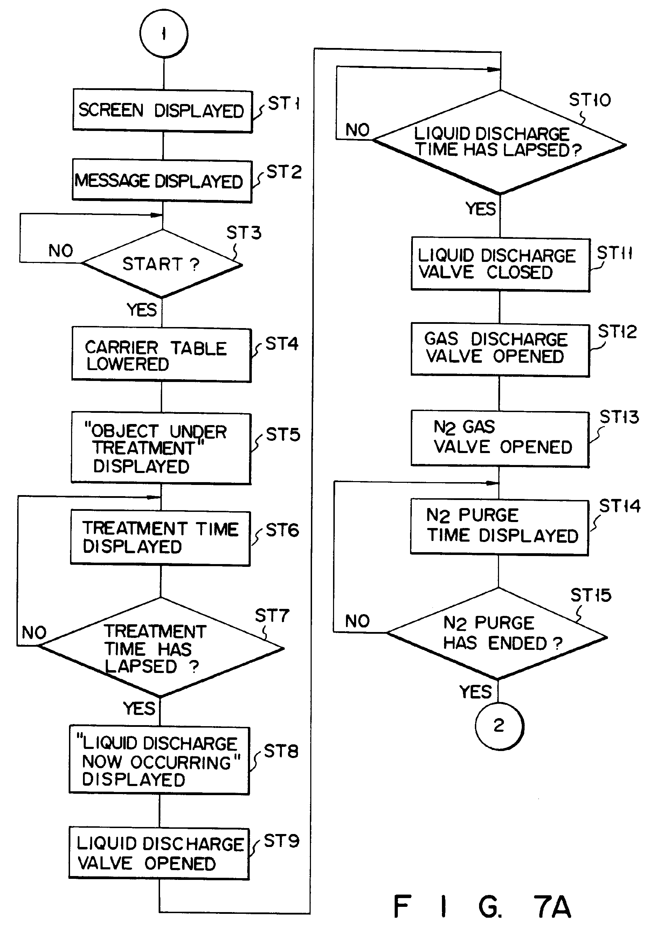

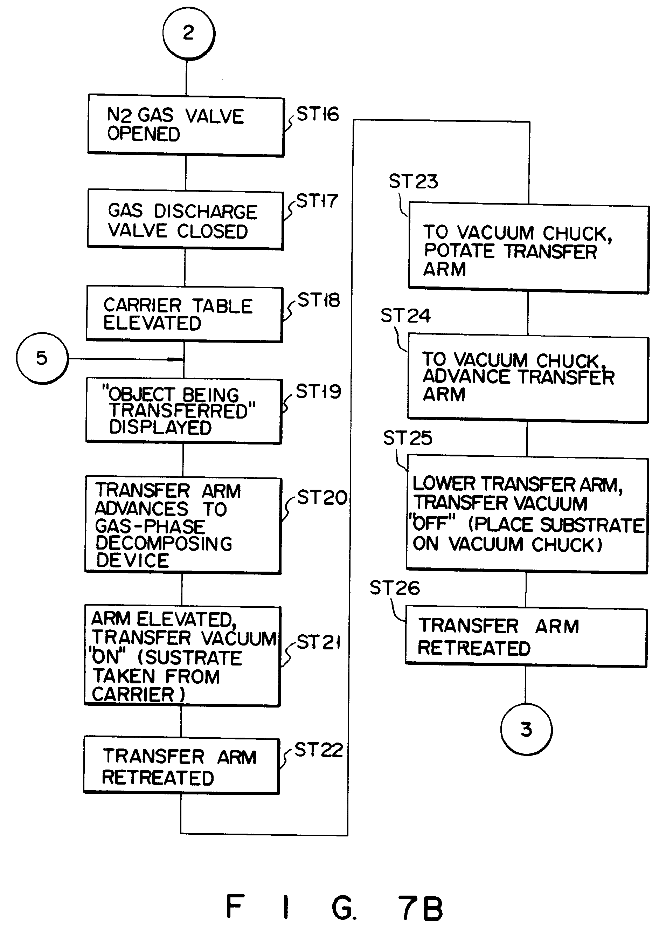

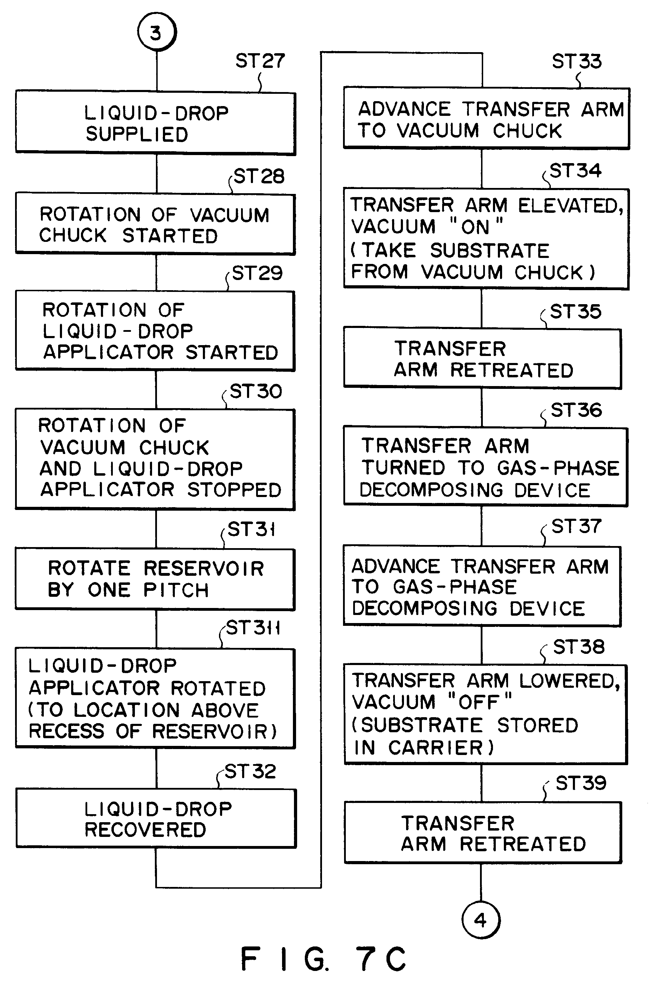

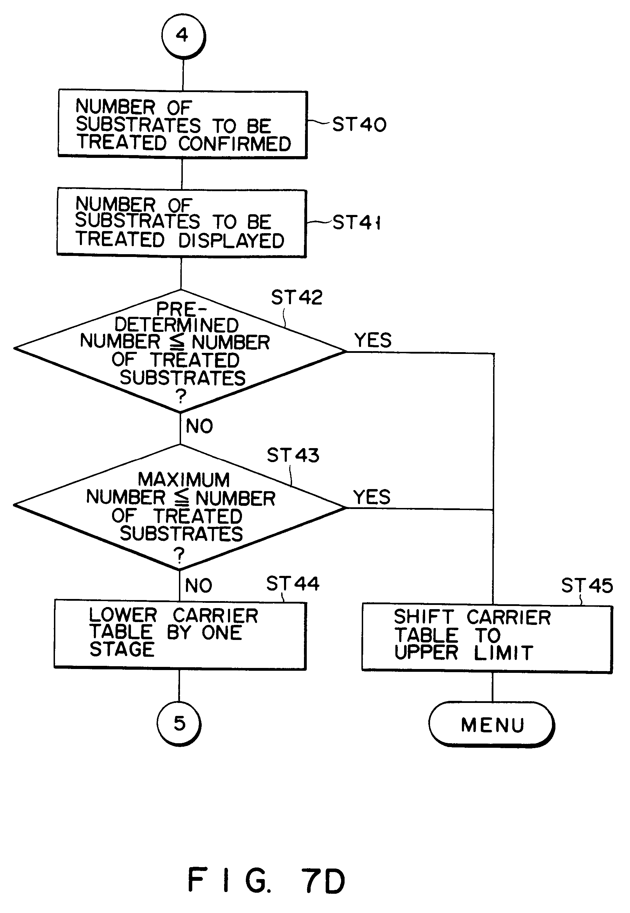

Figs. 7A to 7D are flowcharts for illustrating the operation of the control device 104. Hereinafter, the operation of the semiconductor treatment apparatus of the first embodiment will now be described in detail with reference to Figs. 7A to 7D and Figs. 2 and 3.

The devices 101 to 103 are arranged at predetermined locations in the apparatus 15 for producing a clean-room. The high-purity fluoride liquid (e.g., hydrofluoric acid) 4 is introduced in the container 2, after the carrier table 3 has been elevated. The carrier 5 in which semiconductor substrates are set is arranged on the carrier table 3. Then, the carrier table 3 is lowered, and the container 2 is sealed by the cover 1 coupled to the carrier table 3 (Steps ST1 to ST4). The high-purity fluoride liquid 4 is evaporated and filled in the sealed container 2. Thus, an oxide film over the surface of a semiconductor substrate set on the carrier 5 is dissolved. As a result, liquid-drops containing impurities are formed on the surface of the substrate. (Steps ST5 to ST7). After the substrate is left for a predetermined time period, the fluoride solution 4 is discharged (Steps ST8 to ST11). Then, a high-purity inert gas (e.g., N₂ gas) is caused to flow into the container 2. At this time, a difference in pressure between the inside of container 2 and the outside occurs, and the vapor of high-purity fluoride solution 4 is discharged to the outside of container 2 (Steps ST12 to ST17). Thereafter, the carrier table 3 is elevated (Steps ST18). In cooperation with the elevation of the carrier table 3, the arm 13 of substrate transfer device 103 takes out one of the semiconductor substrates from the carrier 5 and sets it on the substrate supporting device (e.g., vacuum chuck) 6. The substrate supporting device 6 is made of a chemically inactive material such as fluorine-based resin (Steps ST19 to ST26). A liquid-drop 14 of fluoride solution (e.g., high-purity 1% HF (hydrofluoric acid) solution) is fallen in that one of, e.g., 25 liquid-drop retainer sections 10 of the liquid-drop applicator 8, which is located above the center of the substrate 12. The liquid-drop 14 is retained by the liquid-drop retainer 10 by virtue of surface tension. The liquid-drop applicator 8, like the substrate supporting device 6, is made of fluorine-based resin (Step ST27). The substrate supporting device 6 and the liquid-drop applicator 8 are rotated in a cooperating manner, and the liquid-drop 14 retained by the retainer 10 is caused to apply to the entire surface of semiconductor substrate 12 spirally from the center to the periphery thereof. Thus, the dissolved oxide film on the surface of semiconductor substrate 12, as well as the impurities contained in the dissolved oxide film, is absorbed in the liquid-drop 14. The rotation speed of the substrate supporting device 6 and liquid-drop applicator 8 is controlled so that the speed of applying the liquid-drop 14 can be kept constant (Steps ST28 to ST29). After the liquid-drop 14 has been completely applied to the surface of semiconductor substrate 12, the liquid-drop 14 is moved away from the substrate 12 and is stored by the liquid-drop collecting and preserving device 9. In the same manner as the liquid-drop 14 is applied to the surface of substrate 12, the liquid-drop 14 is applied to the surface of collecting and preserving device 9. When the liquid-drop 14 is brought into contact with one of, e.g., 25 recesses 11 of the collecting and preversing device 9, the rotation of the substrate supporting device 6 and the liquid-drop applicator 8 is stopped and the collecting and preserving device 9 is rotated by the pitch of recess 11. Then, the liquid-drop 14 falls into the recess 11 by the gravity and surface tension (Steps ST30 to ST32). Thereafter, the substrate transfer device 103 restores the substrate 12 to the carrier 5, and a series of operations have been completed (Steps ST33 to ST39). In this state, the positions of the substrate supporting device 6 and the liquid-drop collecting and preserving device 9 are determined such that the liquid-drop retainer 10, which has not yet been used for the 'recovery of liquid-drop, is situated at the center of the supporting device 6. Similar operations are carried out to treat a single lot of substrates (Steps ST40 to ST45).

As has been described above, the substrate 12 is taken out of the carrier 5, the impurities on the substrate are stored, and the substrate 12 is restored to the carrier 5. This operations are repeated, and samples of all substrates can be stored. Impurity analysis of the stored sample is conducted by using an analyzer, for example, a frameless atom light-absorption type spectral analyzer.

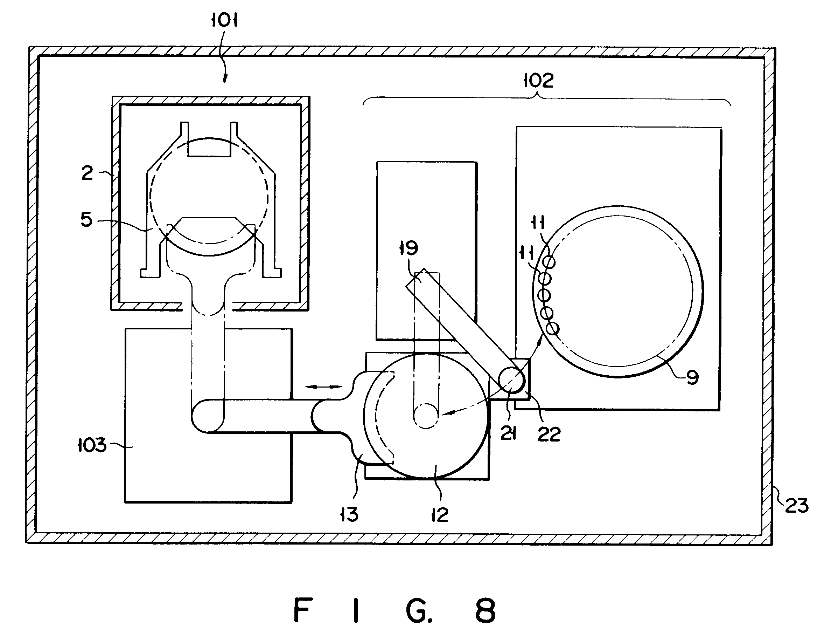

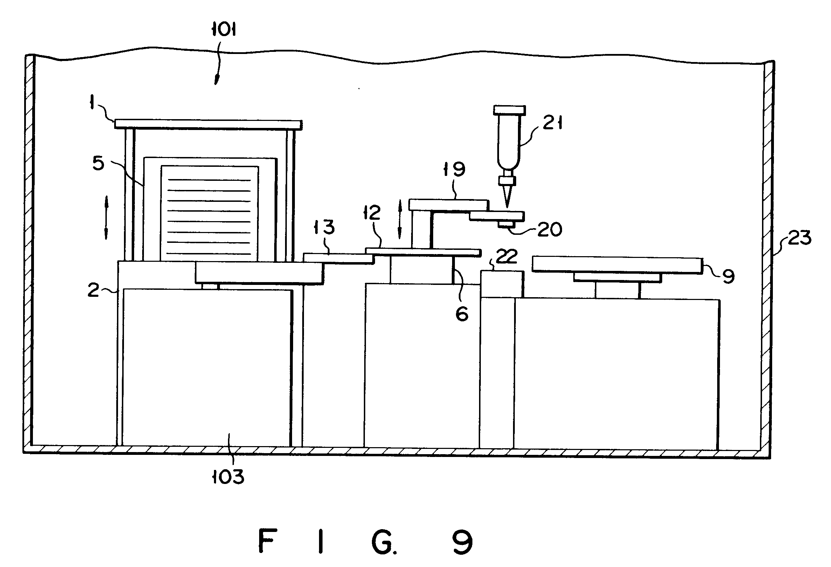

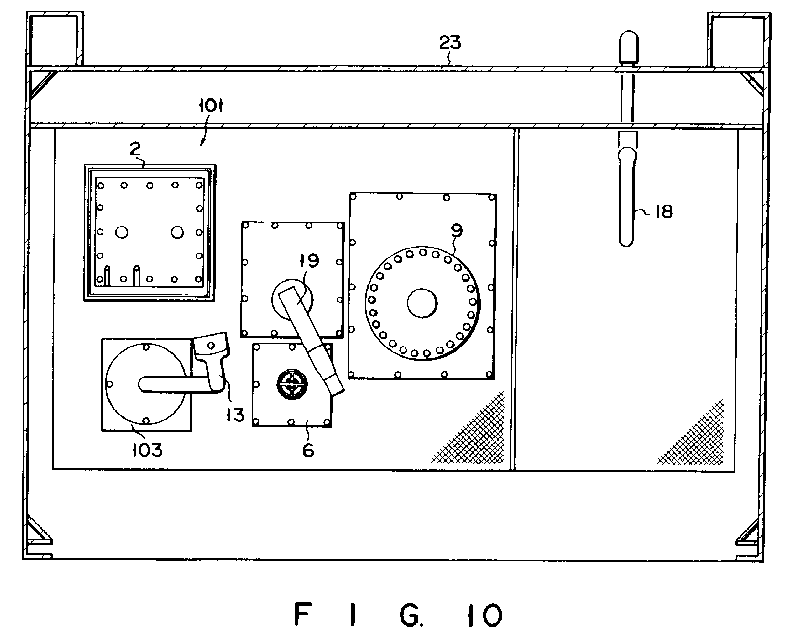

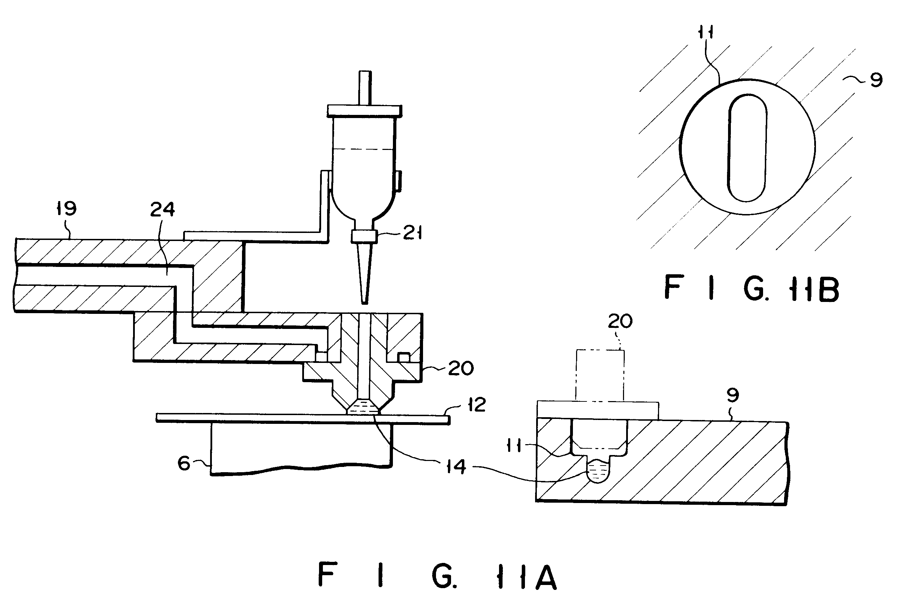

Figs. 8 to 10 show a second embodiment of the semiconductor treatment apparatus according to the present invention, wherein the apparatus shown in Figs. 2 to 6 has been partially improved.

According to the second embodiment, like in the first embodiment, a carrier table (not shown) is arranged in a resin-made container 2 which can be sealed by a resin-made cover 1. A carrier 5 for carrying semiconductor substrates is disposed on the carrier table. A high-purity fluoride solution is put in the container 2. When the cover 1 is closed, vapor of the high-purity fluoride is filled in the container, and a reaction product is formed by the reaction between the fluoride and an oxide film on the surface of the semiconductor substrate. Also, there is provided a substrate transfer device 103 for transferring the semiconductor substrate between the carrier 5 and a substrate supporting device (e.g., a vacuum chuck) 6.

The semiconductor treatment apparatus shown in Figs. 8 to 10 has a liquid-drop applicator 19 with a rotational shaft. The applying device 19 can suck and support a liquid-drop retainer 20 formed of fluorine resin (e.g., PTFE). The rotational axis of the applying device 19 is positioned such that the liquid-drop retained by the liquid-drop retainer 20 is aligned with above the center of substrate 12, i.e., the center of the substrate supporting device 6. A dispenser 21 for supplying a liquid drop of, e.g., fluoride solution to the liquid-drop retainer 20 is provided above the retainer 20 supported by the liquid-drop applicator 19. In order to keep the liquid-drop that has been applied to the surface of the substrate 12, there is provided a circular liquid-drop collecting an preserving device (e.g., a reservoir) 9 having a plurality of recesses 11 along its periphery. Also, a recovering box 22 for recovering the liquid-drop retainer 20 is installed. The devices 101 to 103 are housed in a clean booth 23, and isolated from the outside space. The remote control of devices 101 to 103 can be performed, by enabling a control device to drive a control motor or the like to establish the operational timings of the devices 101 to 103.

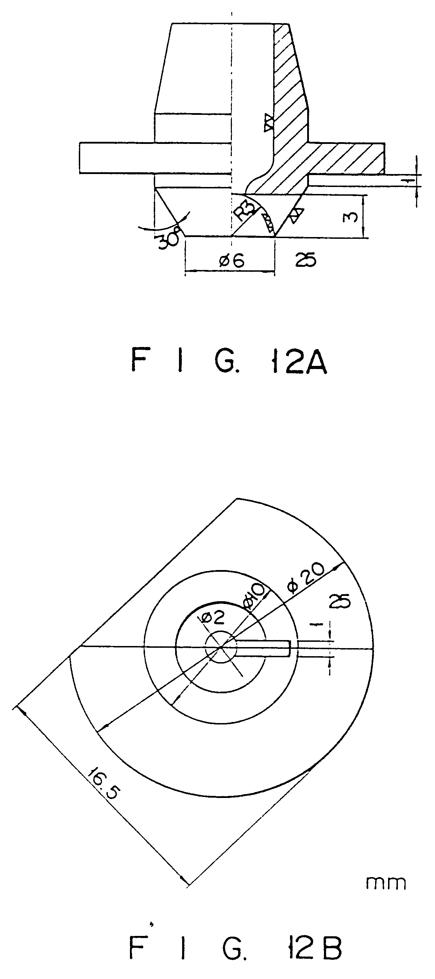

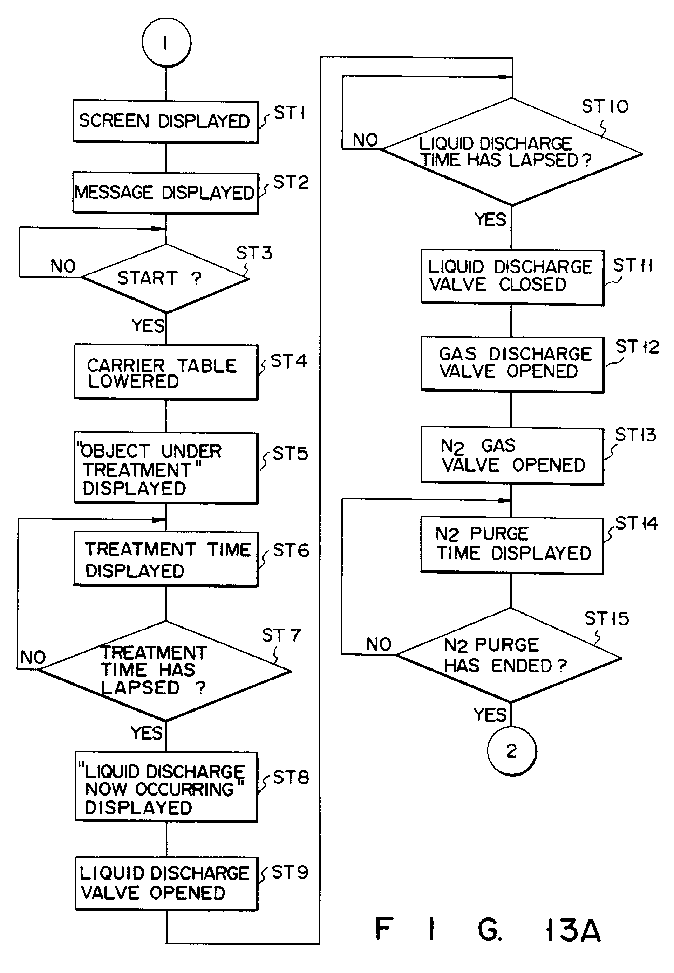

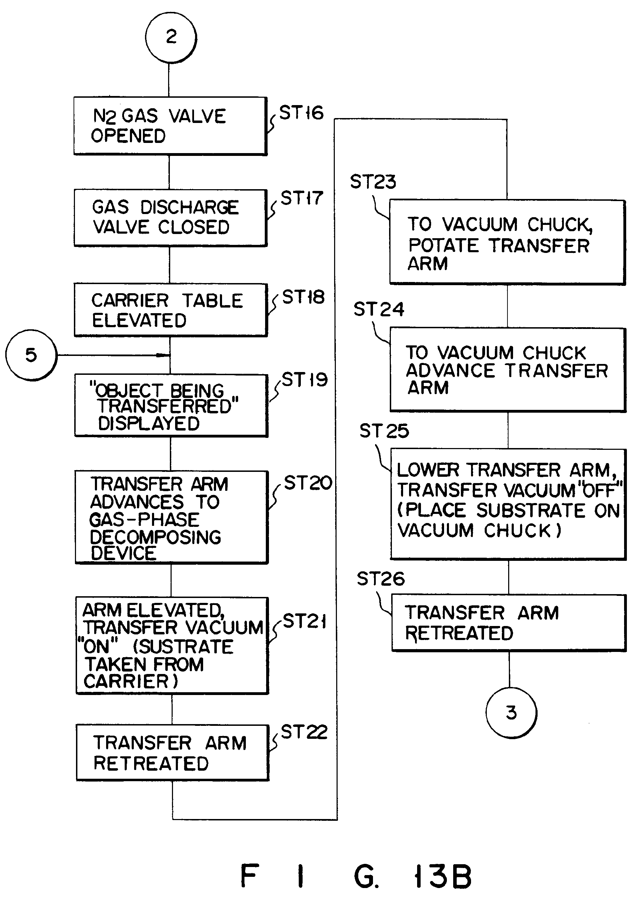

Figs. 11A and 11B show in detail the liquid-drop recovering device 9 and liquid-drop applicator 19 shown in Figs. 8 to 10. Figs. 12A and 12B show the liquid-drop retainer 20 in detail.

In the initial state, the liquid-drop retainers 20, which have not yet been used, are set in the recesses 11 formed along the periphery of the liquid-drop collecting and preserving device 9. The liquid-drop applicator 19 for sucking and supporting the retainer 20 has a suction pipe 24. The suction pipe 24 is connected, for example, to a pump, and can suck the liquid-drop retainer 20 by virtue of negative pressure.

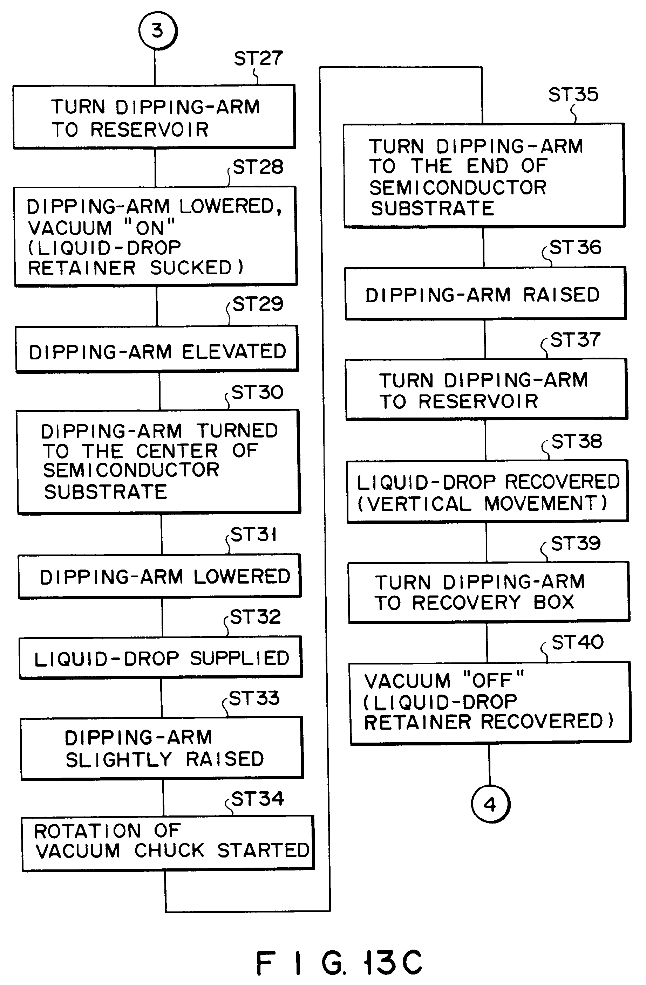

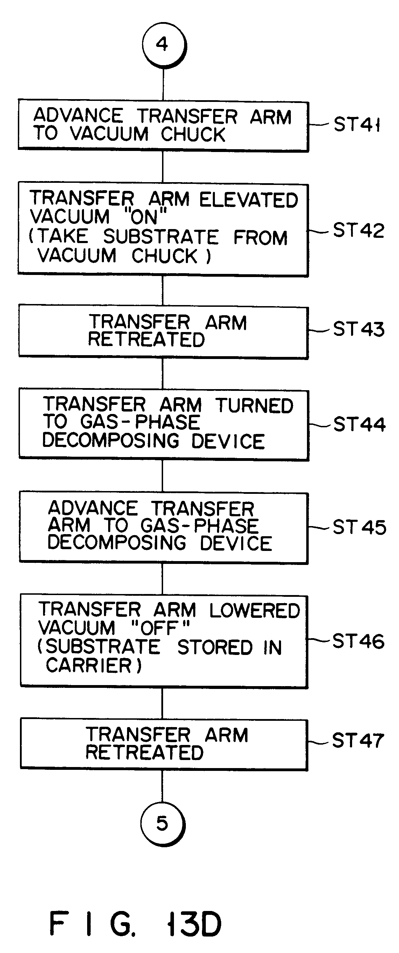

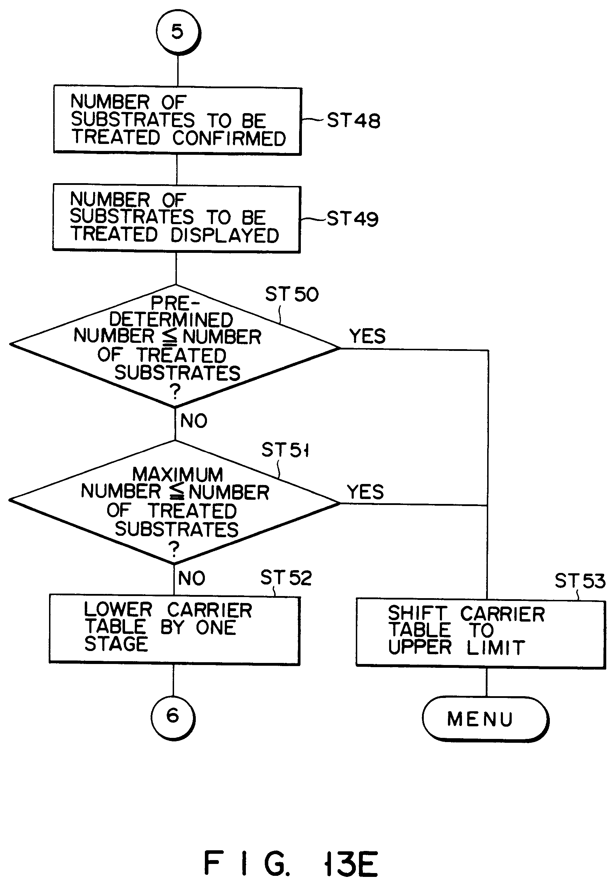

Figs. 13A to 13E are flowcharts illustrating the operation of the control device. The operation of the semiconductor treatment apparatus of the second embodiment will now be described with reference to Figs. 13A to 13E and Figs. 8 to 12.

The semiconductor substrate 12 is set on the substrate supporting device 6 by the same operations as in the first embodiment (Steps ST1 to ST26). Then, the liquid-drop applicator 19 sucks and supports, by virtue of vacuum, one of the liquid-drop retainers 20 set in the recesses 11 of the liquid-drop recovering device 9 (Steps ST27 and ST28). After the liquid-drop retainer 20 is shifted to the center of the substrate 12 (Steps ST29 to ST31), the dispenser 21 drops a liquid-drop 14 of fluoride solution (e.g., high-purity 1% (hydrofluoric acid) solution) into the retainer 20 (Steps ST32 and ST33). In accordance with the rotation of substrate 12, the liquid-drop applicator 19 rotates such that the liquid-drop 14 retained by the retainer 20 slides over the surface of substrate 13 from the center to the periphery of substrate 12. The rotation speed of the substrate supporting device 6 and liquid-drop applicator 19 are controlled by a computer program, so that the speed of applying the liquid-drop 14 to the surface of substrate 12 can be kept constant (Steps ST34 to ST35). When the liquid-drop 14 reaches the periphery of substrate 12, the liquid-drop 14, while being retained by the retainer 20, is shifted to the position above the recess 11 in which the retainer 20 was previously set (Steps ST36 and ST37). The retainer 20 retaining the liquid-drop 14 is placed in the recess 11, and the bottom face of liquid-drop 14 is brought into contact with the bottom of recess 11. The liquid-drop 14 wets the bottom face of recess 11 until the contact angle between the drop 14 and the bottom face of recess 11 becomes equal to an advancing contact angle. In other words, if the bottom face of recess 11 is formed in a circular shape, for example, as shown in Fig. 11, the drop 14 spreads over the entire bottom face of recess 11. Consequently, the liquid-drop 14 is narrowed at its middle part, by virtue of a high tensile stress acting between the retainer 20 and the drop 14. Then, the drop 14 begins to be separated from the inner wall of retainer 20 by the function of a groove 25 formed in the retainer 20 (see Figs. 12A and 12B). Once the separation of the liquid-drop 14 begins, the separation is continued by the weight of the drop 14 itself. Finally, the entire liquid-drop 14 falls in the recess 11, and the recovery of the drop 14 is completed (Step ST38). After the recovery of the liquid-drop 14, the liquid-drop retainer 20 is shifted to the position of the recovery box 22, and is recovered in the recovery box 22 (Steps ST39 to ST40). The substrate 12, which has been treated, is restored into the carrier 5 by the substrate transfer device 103 (Steps ST41 to ST47). Thus, the series of operations have been performed to obtain the analysis samples of a single lot of substrates, and impurities on the surface of substrates have been recovered (Steps ST48 to ST53).

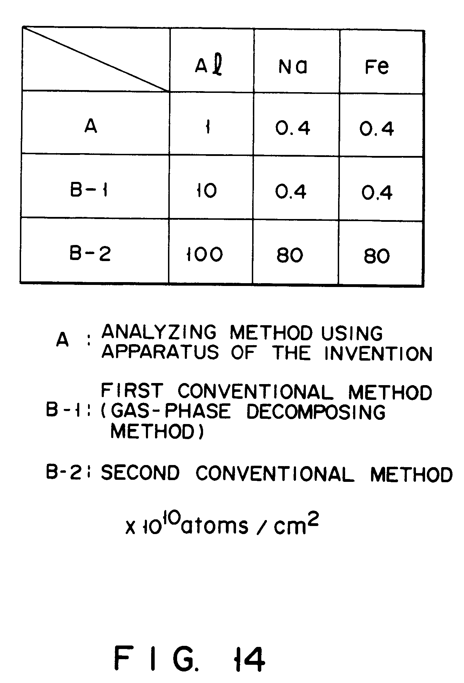

In the prior art, the limit value of impurity detection is about 10¹¹ atoms/cm². However, with the use of the apparatus of the present invention, the limit value of impurity detection can be lowered to 10⁹ atoms/cm² (see Fig. 14). In addition, the sample liquid can automatically be recovered and analyzed by remote control, without touching the devices or substrate by the hand. Thus, compared to the conventional process, an impurity analysis can be conducted with shorter time, high precision and high reliability. Furthermore, safety is enhanced, since an operator does not directly handle a poisonous liquid such as fluoride solution. As a result, the number of staff members and the time required for impurity analysis can be reduced 50%.

In the first and second embodiments, the liquid-drop 14 used for recovering impurities was fluoride solution (e.g., high-purity 1% HF (hydrofluoric acid) solution). However, a water solution including an oxidizing agent, a water solution including a reducing agent, or a water solution including both the oxidizing agent and reducing agent. As such a water solution, there are hydrochloric acid, nitric acid, hydrogen peroxide, etc. In addition, in the embodiments, the amount of the liquid-drop was 100 µℓ. However, this amount can be varied by changing the shape of the liquid-drop retainer, the shape of the recess of the reservoir, and the discharge amount of the dispenser.

Reference signs in the claims are intended for better understanding and shall not limit the scope.

## Claims

1. A semiconductor substrate treatment apparatus comprising:
- decomposing means (101) for dissolving the surface of a semiconductor substrate by exposing it to a vapor;
- substrate supporting means (6) for supporting a substrate;
- substrate transfer means (103) for transferring a substrate between said decomposing means and said substrate supporting means;
- liquid-drop applying means (8,10;19,20) for sweeping the surface of a substrate when supported by said supporting means with a liquid-drop such that said liquid-drop remains in contact with both the liquid-drop applying means and the substrate surface during sweeping; and
- liquid-drop collecting and preserving means (9,11) for collecting and preserving for subsequent impurity analysis the liquid-drop after it has been swept across the entire surface of said substrate.

2. A semiconductor substrate treatment apparatus according to claim 1, characterized by means (15) providing a clean-room in which the decomposing means, the substrate supporting means, the substrate transfer means, the liquid-drop applying means, and the liquid-drop collecting and preserving means are housed.

3. A semiconductor substrate treatment apparatus according to claim 1 or 2, characterized in that said substrate supporting means (6) is a vacuum chuck.

4. A semiconductor substrate treatment apparatus according to any one of the preceding claims, characterized in that the liquid-drop applying means (8) is circular and has a plurality of liquid-drop retainer sections (10) along a periphery thereof for retaining the liquid-drop by virtue of surface tension.

5. A semiconductor substrate treatment apparatus according to any one of the preceding claims, characterized in that the liquid-drop collecting and preserving means (9) is circular and has a plurality of recesses (11) along a periphery thereof.

6. A semiconductor substrate treatment apparatus according to one of claims 1 to 4, characterized in that the liquid-drop applying means (19) can suck and support a retainer (20) for retaining a liquid-drop by virtue of surface tension and can be pivoted about a rotational axis positioned such that the liquid-drop is swept spirally over the surface of the substrate when the liquid-drop applying means and the substrate are rotated.

7. A semiconductor substrate treatment apparatus according to claim 6, characterized in that the liquid-drop collecting and preserving means (9) is circular and has a plurality of recesses (11) along a periphery thereof.

8. A semiconductor substrate treatment apparatus according any one of the preceding claims, characterized by control means (104) for operating said semiconductor treatment apparatus.

## Patentansprüche

1. Halbleitersubstrat-Behandlungsvorrichtung, umfassend:
- eine Zersetzungsvorrichtung (101) zur Auflösung der Oberfläche eines Halbleitersubstrats dadurch, daß es einem Dampf ausgesetzt wird;
- eine Substratstützvorrichtung (6) zur Stützung eines Substrats;
- eine Substrattransportvorrichtung (103) zum Transportieren eines Substrates zwischen der Zersetzungsvorrichtung und der Substratstützvorrichtung;
- eine Flüssigkeitstropfen-Aufbringungsvorrichtung (8, 10; 19, 20) zur Überstreichung der Oberfläche eines von der Stützvorrichtung gestützten Substrates mit einem Flüssigkeitstropfen, so daß der Flüssigkeitstropfen in Berührung bleibt sowohl mit der Flüssigkeitstropfen-Aufbringungsvorrichtung als auch der Substratoberfläche während dem Überstreichen; und
- eine Flüssigkeitstropfen-Sammel- und -Aufbewahrungsvorrichtung zum Sammeln und Aufbewahren des Flüssigkeitstropfens nachdem er über die gesamte Fläche des Substrates gestrichen wurde zur folgenden Verunreinigungsanalyse.

2. Halbleitersubstrat-Behandlungsvorrichtung nach Anspruch 1, gekennzeichnet durch eine Vorrichtung (15) zur Schaffung eines Reinraumes, in welcher die Zersetzungsvorrichtung, die Substratstützvorrichtung, die Substrattransportvorrichtung, die Flüssigkeitstropfen-Aufbringungsvorrichtung, und die Flüssigkeitstropfen-Sammel- und -Aufbewahrungsvorrichtung untergebracht sind.

3. Halbleitersubstrat-Behandlungsvorrichtung nach Anspruch 1 oder 2, dadurch gekennzeichnet, daß die Substratstützvorrichtung (6) ein Vakuumchuck ist.

4. Halbleitersubstrat-Behandlungsvorrichtung nach einem der vorhergehenden Ansprüche, dadurch gekennzeichnet, daß die Flüssigkeitstropfen-Aufbringungsvorrichtung (8) kreisförmig ist und eine Vielzahl von Flüssigkeitstropfen-Rückhalteabschnitten (10) entlang ihrer Peripherie hat zur Zurückhaltung der Flüssigkeitstropfen mittels der Oberflächenspannung.

5. Halbleitersubstrat-Behandlungsvorrichtung nach einem der vorhergehenden Ansprüche, dadurch gekennzeichnet, daß die Flüssigkeitstropfen-Sammel- und -Aufbewahrungsvorrichtung (9) kreisförmig ist und eine Vielzahl von Vertiefungen (11) entlang ihrer Peripherie hat.

6. Halbleitersubstrat-Behandlungsvorrichtung nach einem der Ansprüche 1 bis 4, dadurch gekennzeichnet, daß die Flüssigkeitstropfen-Aufbringungsvorrichtung (19) ein Rückhaltegefäß (20) ansaugen und halten kann, welches zur Zurückhaltung eines Flüssigkeitstropfens mittels der Oberflächenspannung dient, und um eine so positionierte Rotationsachse geschwenkt werden kann, daß der Flüssigkeitstropfen spiralförmig über die Oberfläche des Substrates gestrichen wird, wenn die Flüssigkeitstropfen-Aufbringungsvorrichtung und das Substrat gedreht werden.

7. Halbleitersubstrat-Behandlungsvorrichtung nach Anspruch 6, dadurch gekennzeichnet, daß die Flüssigkeitstropfen-Sammel- und -Aufbewahrungsvorrichtung (9) kreisförmig ist und eine Vielzahl von Vertiefungen (11) entlang ihrer Peripherie hat.

8. Halbleitersubstrat-Behandlungsvorrichtung nach einem der vorhergehenden Ansprüche, gekennzeichnet durch eine Steuervorrichtung (104) zum Betreiben der Halbleiterbehandlungsvorrichtung.

## Revendications

1. Appareil de traitement de substrat semiconducteur comprenant :
un moyen de décomposition (101) pour dissoudre la surface d'un substrat semiconducteur en l'exposant à une vapeur ;
un moyen de support de substrat (6) pour supporter un substrat ;
un moyen de transfert de substrat (103) pour transférer un substrat entre ledit moyen de décomposition et ledit moyen de support de substrat ;
un moyen d'application de goutte de liquide (8, 10 ; 19, 20) pour balayer la surface d'un substrat lorsqu'il est supporté par ledit moyen de support à l'aide d'une goutte de liquide de manière à ce que ladite goutte de liquide reste en contact avec à la fois le moyen d'application de goutte de liquide et la surface du substrat au cours du balayage ; et
un moyen de collecte et de préservation de goutte de liquide (9, 11) pour collecter et préserver en vue d'une analyse d'impureté ultérieure la goutte de liquide après qu'elle a été balayée sur la totalité de la surface dudit substrat.

2. Appareil de traitement de substrat semiconducteur selon la revendication 1, caractérisé par un moyen (15) permettant de constituer une salle blanche dans laquelle le moyen de décomposition, le moyen de support de substrat, le moyen de transfert de substrat, le moyen d'application de goutte de liquide, et le moyen de collecte et de préservation de goutte de liquide sont placés.

3. Appareil de traitement de substrat semiconducteur selon la revendication 1 ou 2, caractérisé en ce que ledit moyen de support de substrat (6) est constitué par un plateau à bridage par le vide.

4. Appareil de traitement de substrat semiconducteur selon l'une quelconque des revendications précédentes, caractérisé en ce que le moyen d'application de goutte de liquide (8) est circulaire et comporte une pluralité de sections de retenue de goutte de liquide (10) le long de sa périphérie pour retenir la goutte de liquide grâce à une tension superficielle.

5. Appareil de traitement de substrat semiconducteur selon l'une quelconque des revendications précédentes, caractérisé en ce que le moyen de collecte et de préservation de goutte de liquide (9) est circulaire et comporte une pluralité d'évidements (11) le long de sa périphérie.

6. Appareil de traitement de substrat semiconducteur selon l'une quelconque des revendications 1 à 4, caractérisé en ce que le moyen d'application de goutte de liquide (19) peut aspirer et supporter un dispositif de retenue (20) pour retenir une goutte de liquide grâce à une tension superficielle et en ce qu'il peut pivoter par rapport à un axe de rotation placé de manière à ce que la goutte de liquide soit balayée en spirale sur la surface du substrat lorsque le moyen d'application de goutte de liquide et le substrat sont mis en rotation.

7. Appareil de traitement de substrat semiconducteur selon la revendication 6, caractérisé en ce que le moyen de collecte et de préservation de goutte de liquide (9) est circulaire et comporte une pluralité d'évidements (11) le long de sa périphérie.

8. Appareil de traitement de substrat semiconducteur selon l'une quelconque des revendications précédentes, caractérisé par un moyen de commande (104) pour le fonctionnement dudit appareil de traitement de semiconducteur.
